Europäisches Patentamt

European Patent Office

Office européen des brevets

(11) Publication number: **0 129 618**
**B1**

## EUROPEAN PATENT SPECIFICATION

(45) Date of publication of patent specification: **04.05.88**

(21) Application number: **83303004.2**

(22) Date of filing: **25.05.83**

(51) Int. Cl.⁴: **H 03 L 1/02**

(54) Temperature controlled crystal oscillator.

(43) Date of publication of application:
**02.01.85 Bulletin 85/01**

(45) Publication of the grant of the patent:
**04.05.88 Bulletin 88/18**

(84) Designated Contracting States:
**CH DE FR LI**

(56) References cited:
**FR-A-2 458 942**
**GB-A-1 352 808**
**US-A-3 821 665**
**US-A-4 107 629**

(73) Proprietor: **STC PLC**
**10, Maltravers Street**
**London, WC2R 3HA (GB)**

(72) Inventor: **Rokos, George Hedley Storm**
**126 Wymondley Road**
**Hitchin Hertfordshire (GB)**
Inventor: **Wilson, James Stanley**
**39 Fold Croft**
**Harlow Essex (GB)**

(74) Representative: **Dennis, Mark Charles**
**STC Patent Department Edinburgh Way**
**Harlow Essex CM20 2SH (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

The present invention relates to temperature compensated crystal oscillators.

Crystal oscillators are widely employed in electronic equipment, usually in situations where a precise frequency of oscillation is required. However the natural resonant frequency of a crystal is a function of temperature, and for some applications the operating range of temperature is so great, having regard to the frequency stability requirements, that special measures have to be taken to reduce the effects of temperature variations upon the operating frequency of the oscillator. This reduction can be achieved by maintaining the crystal at a constant temperature in a temperature controlled oven, but this requires a relatively large amount of space, and involves the consumption of a relatively large amount of power. This is the approach used in the oven controlled crystal oscillator (OCXO). In a temperature compensated crystal oscillator (TCXO) an alternative approach to obtaining the required reduction in temperature sensitivity is obtained by the use of a variable reactance element in the feedback path of the oscillator to 'pull' the forced resonant frequency of the oscillator in such a way as to compensate the changes that would otherwise result from the changes in the natural resonant frequency of the crystal. Typically the variable reactance element of a TCXO is a varicap diode whose reactance is controlled by altering the d.c. voltage applied across its terminals. Various methods have been proposed for generating the requisite compensation voltage for the varicap diode, but to provide a reasonable stability over the temperature range from −40°C to +85°C the method most commonly used to date is provided by a ladder network of three thermistors and five resistors. The values of the components in this ladder are chosen having regard to the particular temperature characteristic exhibited by the uncompensated crystal, and this varies from oscillator to oscillator because the variations between nominally identical crystals prove to be quite significant. As a result, compensation with this form of ladder network typically requires the selection of appropriate values of resistors from three decades of 1% accuracy E 96 series resistors (resistors having 96 preferred values per decade).

The present invention is concerned with an alternative compensation voltage that does not require the use of the thermistor resistor ladder network, and which affords the possibility of being able to use lower accuracy resistors in a series having a fewer preferred values per decade. This is achieved by the use of a temperature sensor whose output is connected to drive the frequency pulling control element via a Chebyshev-like power series function generator and summing amplifier.

The use of a power series function generator for temperature compensation of a crystal oscillator has previously been proposed in the specification of United States Patent US—A—3821665, but that specification describes the use of a 'standard' power series polynomial expansion of the form $\Sigma a_n x^n$ rather than a Chebyshev one.

According to the present invention there is provided a temperature compensated crystal oscillator consisting of a crystal oscillator circuit and a temperature sensitive compensation circuit, wherein the crystal oscillator circuit has a frequency pulling control element connected in its frequency selective positive feedback path, wherein the temperature sensitive compensation circuit includes a temperature sensor whose output is connected to drive the control element via a power series function generator and a summing amplifier, wherein the temperature sensor is adapted to provide an electrical output f(t) that is a monotonically varying function of temperature, wherein the summing amplifier is adapted to provide a weighted sum of the power series function generator outputs, which sum is applied to the control element, which temperature compensated crystal oscillator is characterised in that the power series function generator is adapted to generate a series of Chebyshev-like outputs of which the $n^{th}$ output is a polynomial function in f(t) of order $(n-1)$, and in that the summing amplifier sums four or more different outputs of the power series function generator.

There follows a further description of the background to the invention and a description of a temperature compensated crystal oscillator embodying the invention in a preferred form.

It is usual to use an AT-cut crystal for a crystal oscillator, and the frequency temperature characteristics of such AT-cut crystals are predominately cubic, and the slope at the point of inflection, which typically occurs at about 25°C, depends upon the angle of the cut.

The compensating voltage is required to have a voltage/temperature characteristic V(T) having a form which is substantially the mirror image of the frequency/temperature characteristic of the particular crystal being compensated. This characteristic curve V(T) can be synthesised using the Weierstrass theorem by a power series of the form

$$V(T)=A_0+A_1(T-T_0)+A_2(T-T_0)^2+A_3(T-T_0)^3+ \ldots +A_n(T-T_0)^n$$

where

V(T) is the required compensating voltage,

T is the working temperature,

$T_0$ is the inflection temperature, and

$A_0$, $A_1$, $A_2$ etc. are the summing coefficients.

This is the basis of the oscillator described in United States Patent Specification No. 3821665 to which previous reference has been made.

# 0 129 618

The error between V(T) and the required compensating voltage is in principle dependent upon the number of terms included in the power series. In practice it will also depend upon the precision with which the required summing coefficients can be realised. For this particular application the dominant summing coefficients are the linear and cubic terms, and so in general principle it will not be necessary to use more than the first four terms of the series. In practice however, having regard to the effects of errors, according to the present invention the terms $(T-T_0)^n$, are not generated, but Chebyshev-like polynomials. Normalised Chebyshev polynomials have the useful property that the excursion over the temperature range of interest is minimised, and this reduces the effects of errors in their coefficients. Also, by choosing the appropriate angle of cut for the crystal to provide minimum excursion of the natural resonant frequency of the crystal over the required temperature range, V(T) approaches close to the third order Chebshev polynomial $C_3(x)=4x^3-3x$ (where $x=T-T_0$). Cubic, and to a lesser extent linear terms, are particularly significant under these circumstances, and so the summing coefficients of the Chebyshev polynomials $C_3$ and $C_1$ need to be selected with reasonable accuracy, whereas those of the other terms can be selected with reduced proportional accuracy because their contribution to the summed signal is small. Furthermore, any unallowed for departure from true Chebyshev form in the generation of the Chebshev-like polynomials will have a smaller effect upon errors in V(T) than corresponding errors used in generating a straight $(T-T_0)^n$ expansion since part of the summation of the polynomials to generate V(T) has already been done. Overall, by using Chebyshev-like polynomials (i.e. polynomials in which the excursion over the required temperature range is reduced close to a minimum) the accuracy to which the polynomials themselves are generated, and the accuracy to which their weighted sum is formed to provide V(T), can be reduced. The magnitudes of the individual summing coefficients required to be used to form the weighted sum are calculated by using a standard linear regression technique upon the measured values of the Chebyshev-like curves generated by the power series function generator and of the required V(T) at selected points in the required working temperature range.

The oscillator consists of an oscillator circuit and a temperature sensitive compensation circuit. The oscillator is provided by an amplifier having a frequency selective positive feedback path incorporating a crystal and a varicap diode. The temperature sensitive compensation circuit is provided by a network which provides a d.c. voltage output V(T) across the varicap diode that exhibits the appropriate function of temperature to force the frequency of oscillation in such a way as to hold it within required limits over the desired working temperature range.

The preferred way of implementing the power series function generator and summing amplifier of the compensation network is by menas of an integrating circuit. Under these circumstances it is clearly attractive to employ the same integrated circuit for the construction of the temperature sensor. A particularly convenient way of achieving this end is to make use of the substantially linear temperature dependence of the base-emitter voltage of integrated circuit transistors. In this particular embodiment this effect is used to provide a sensor having two parts, one producing an output current $I_A$ with a negative temperature coefficient, and the other producing an output current $I_B$ with an equal, but opposite, positive temperature coefficient.

It is also convenient to use another part of the same integrated circuit to provide varicap diode and the rest of the oscillator circuit, with the exception of the crystal itself. In some circumstances a separate varicap diode may be preferred because of the greater voltage swing then obtainable. Finally a further part of the same integrated circuit is conveniently used to provide a voltage reference. This integrated circuit is conveniently a semi-custom design analogue array integrated circuit. More than one such array may be required to accommodate all the circuitry.

The compensation network consists essentially of a voltage reference, a two-part temperature sensor and two analogue multipliers, three current-to-voltage signal converters, and a summing amplifier. With the exception of a number of resistors that are difficult to implement adequately in integrated circuit form, all the components of the compensation network are formed in a single integrated circuit.

The voltage reference has an unregulated voltage input, and first and second reference voltage outputs. This circuit uses a standard band-gap circuit to generate a constant voltage of 1.2 volts at the base of a transistor. This transistor and another are arranged to operate at different current densities in order to develop a positive temperature coefficient voltage across a resistor. This coefficient is scaled up and added to the negative temperature coefficient of the first-mentioned transistor to give an output of about 1.23 volts with zero temperature coefficient. The constant voltage at the base of the first-mentioned transistor is scaled up by resistor-diode networks. The scale factor is a rational fraction $k=n/m$ where n and m are the number of diodes in the respective networks. Typically the scale factor is 2:1 giving a reference voltage output of about 3.6 volts.

A current source with a substantially linear negative temperature coefficient can be provided by a simple circuit of the type in which the sum of the voltage drop across the base emitter junction of a transistor and that across a resistor is equal to the sum of the voltage drops across the base-emitter junctions of the two transistors each having its base shorted to its collector so that it functions as a diode. Therefore

$$V_{BE}+I_AR=2\ V_{BE},$$

where $V_{BE}$ is the base emitter voltage of a transistor and $I_A$ is the current flowing in the resistor.

3

$V_{BE}$ has a negative temperature coefficient, and therefore $I_A$ will also have a negative temperature coefficient.

A complementary current source with a substantially linear positive temperature coefficient can be provided by a simple circuit of the type in which a constant voltage $V_K$ is applied to the base of a transistor to provide a collector current $I_B$ satisfying the relationship

$$V_K=I_B R+V_{BE}$$

$V_{BE}$ has a negative temperature coefficient, and hence $I_B$ has a positive temperature coefficient.

Each of the two analogue multipliers is provided by a circuit in which four transistors form a cross coupled analogue multiplier structure provided with an active load by two further transistors. The arrangement is such that, for currents $I_P$, $I_Q$, $I_R$ and $I_S$, the output current $I_0$ satisfies the relationship

$$I_0=(I_P-I_S)(I_Q-I_R)/(I_P+I_S)$$

Inspection of this relationship shows that the output current $I_0$ will have a quadratic dependence upon temperature by making $I_P=I_Q=I_A$ and $I_R=I_S=I_B$. This gives the required relationship for one of the multipliers. Its output $I_2$ is thus given by

$$I_2=(I_A-I_B)^2/(I_A+I_B).$$

$(I_A+I_B)$ is temperature invariant, and hence $I_2$ has a simple square law dependence upon temperature.

For the second multiplier $I_P=I_A$ and $I_S=I_B$ to give a temperature invariant divisor in the multiplier equation, while

$$I_Q=I_2+I_{C1} \text{ and } I_R=I_{C2}$$

where $I_{C1}$ and $I_{C2}$ are temperature invariant currents.

$I_3$, the output of multiplier 43, thus satisfies the relationship

$$I_3=(I_A-I_B)((I_A-I_B)^2+(I_{C1}-I_{C2})(I_A+I_B))/(I_A+I_B)^2$$

Thus $I_3$ has a temperature dependence, provided by the sum of a cubic term and a linear term, whose relative magnitude is made close to that of the minimum excursion form of the Chebyshev polynomial $C_3$ by the appropriate choice of values for $I_{C1}$ and $I_{C2}$.

**Claims**

1. A temperature compensated crystal oscillator consisting of a crystal oscillator circuit and a temperature sensitive compensation circuit, wherein the crystal oscillator circuit has a frequency pulling control element connected in its frequency selective positive feedback path, wherein the temperature sensitive compensation circuit includes a temperature sensor whose output is connected to drive the control element via a power series function generator and a summing amplifier, wherein the temperature sensor is adapted to provide an electrical output f(t) that is a monotonically varying function of temperature, wherein the summing amplifier is adapted to provide a weighted sum of the power series function generator outputs, which sum is applied to the control element, which temperature compensated crystal oscillator is characterised in that the power series function generator is adapted to generate a series of Chebyshev-like outputs of which the $n^{th}$ output is a polynomial function in f(t) of order $(n-1)$, and in that the summing amplifier sums four or more different outputs of the power series function generator.

2. An oscillator as claimed in claim 1, characterised in that the highest order output generated by the power series function generator is the output of order three.

3. An oscillator as claimed in claim 1 or 2, characterised in that the crystal is an AT-cut crystal.

4. An oscillator as claimed in any preceding claim, characterised in that the active components of the temperature sensor, power series function generator and summing amplifier are provided on one or more integrated circuits.

5. An oscillator as claimed in claim 4, characterised in that the or each integrated circuit is provided by a semi-custom analogue array.

6. An oscillator as claimed in claim 4 or 5, characterised in that the integrated circuit(s) includes a voltage reference.

7. An oscillator as claimed in claim 4, 5 or 6, characterised in that the integrated circuit(s) includes the frequency pulling control element of the oscillator circuit.

8. An oscillator as claimed in claim 4, 5, 6 or 7, characterised in that the only discrete off-chip components of the integrated circuit circuitry are resistors.

9. An oscillator as claimed in claim 4, 5 or 6, characterised in that the integrated circuit(s) includes the oscillator circuit with the exception of the frequency pulling control element and the crystal itself.

10. An oscillator as claimed in claim 7, characterised in that the integrated circuit(s) includes the oscillator circuit with the exception of the crystal itself.

11. An oscillator as claimed in claim 9 or 10, characterised in that the only discrete off-chip components of the integrated circuit circuitry are resistors and the crystal.

12. An oscillator as claimed in claim 8 or 10, characterised in that said discrete off-chip resistors are 2% accuracy E 24 series resistors.

13. An oscillator as claimed in any claim of claims 4 to 12, characterised in that the temperature sensor includes circuitry adapted to provide substantially linear positive and negative temperature coefficient current outputs of substantially equal coefficient modulus, both derived from the temperature characteristic of the base emitter voltages of elements in the integrated circuit chip.

14. An oscillator as claimed in any preceding claim, characterised in that the frequency pulling control element is a varicap diode.

## Patentansprüche

1. Temperaturstabilisierter Kristalloszillator bestehend aus einem Kristalloszillatorkries und einem temperaturempfindlichen Stabilisierungskreis, wobei der Kristalloszillatorkreis ein frequenzverschiebendes Steuerelement aufweist, das mit seinem frequenzselektiven, positiven Rückkopplungspfad verbunden ist, wobei der temperaturempfindliche Stabilisierungskreis einen Temperatursensor enthält, dessen Ausgang zur Ansteuerung des Steuerelementes über einen Potenzreihen Funktionsgenerator und einen Summierverstärker angeschlossen ist, wobei der Temperatursensor eine elektrische Ausgangsgröße f(t) liefert, die eine monoton variierende Funktion der Temperatur ist, wobei der Summierverstärker eine gewichtete Summe der Ausgangsgrößen aus dem Potenzreihen-Funktionsgenerator liefert, welche Summe dem Steuerelement zugeführt wird, dessen temperaturkompensierter Kristalloszillator dadurch gekennzeichnet ist, daß der Potenzreihen-Funktionsgenerator eine Serie von Chebyshev-ähnlichen Ausgangsgrößen erzeugt, von denen diente Ausgangsgröße eine Polynomfunktion in f(t) der Ordnung (n−1) ist und daß der Summierverstärker vier oder mehr verschiedene Ausgangsgrößen des Potenzreihen-Funktionsgenerators aufsummiert.

2. Oszillator nach Anspruch 1, dadurch gekennzeichnet, daß die Ausgangsgröße mit der höchsten Ordnung, die von dem Potenzreihen-Funktionsgenerator erzeugt wird, die Ausgangsgröße der dritten Ordnung ist.

3. Oszillator nach Anspruch 1 oder 2 dadurch gekennzeichnet, daß der Kristall ein temperaturabhängiger Kristall ist.

4. Oszillator nach einem der vorhergehenden Ansprüche, dadurch gekennzeichnet, daß die aktiven Komponenten des Temperatursensors, des Potenzreihen-Funktionsgenerators und des Summierverstärkers auf einem oder mehreren integrierten Kreisen angeordnet sind.

5. Oszillator nach Anspruch 4, dadurch gekennzeichnet, daß der oder daß jeder integrierte Kreis ein halb anwenderspezifisches (semi-custom) Analogdatenfeld aufweist.

6. Oszillator nach Anspruch 4 oder 5, dadurch gekennzeichnet, daß der oder die integrierten Kreise eine Spannungsreferenz aufweisen.

7. Oszillator nach Anspruch 4, 5 oder 6, dadurch gekennzeichnet, daß der oder die integrierten Kreise das frequenzverschiebende Steuerelement des Oszillatorkreises aufweisen.

8. Oszillator nach Anspruch 4, 5, 6 oder 7, dadurch gekennzeichnet, daß die einzigen diskreten Aus-Chip-Komponenten der integrierten Schaltkreistechnik Widerstände sind.

9. Oszillator nach Anspruch 4, 5 oder 6, dadurch gekennzeichnet, daß der oder die integrierten Kreise den Oszillatorkreis mit Ausnahme des frequenzverschiebenden Steuerelementes und des Kristalles enthalten.

10. Oszillator nach Anspruch 7, dadurch gekennzeichnet, daß oder die integrierten Kreise den Oszillatorkreis mit Ausnahme des Kristalles enthalten.

11. Oszillator nach Anspruch 9 oder 10, dadurch gekennzeichnet, daß die einzigen diskreten Aus-Chip-Komponenten der integrierten Schaltkreistechnik Widerstände und der Kristall sind.

12. Oszillator nach Anspruch 8 oder 10, dadurch gekennzeichnet, daß die genannten diskreten Aus-Chip-Widerstände E 24 Serienwiderstände mit 2% Toleranz sind.

13. Oszillator nach einem der Ansprüche 4 bis 12, dadurch gekennzeichnet, daß der Temperatursensor Stromkreise aufweist, die Stromausgangssignale mit im wesentlichen linearem positivem und negativem Temperaturkoeffizient und mit im wesentlichen gleichem Koeffizienten-Modul liefern, wobei beide von der Temperaturcharateristik der Basis-Emitter-Spannungen von Elementen in dem integrierten Schaltkreis-Chip aubgeleitet sind.

14. Oszillator nach einem der vorhergehenden Ansprüche, dadurch gekennzeichnet, daß das frequenzverschiebende Steuerelement eine Kapazitätsdiode ist.

## Revendications

1. Oscillateur piézoélectrique à compensation de température, constitué d'un circuit oscillateur piézoélectrique et d'un circuit de compensation sensible à la température, dans lequel le circuit oscillateur piézoélectrique a un élément de commande par déplacement de fréquence relié à son trajet de rétroaction positif à sélectivité en fréquence, dans lequel le circuit de compensation sensible à la température comprend un capteur de température dont le signal de sortie est transmis de manière qu'il pilote l'élément de commande par l'intermédiaire d'un générateur de fonctions polynomes et d'un amplificateur d'addition, dans lequel le capteur de température est destiné à donner un signal électrique de sortie f(t) qui est une fonction de la température variant de façon monotone, dans lequel l'amplificateur d'addition est destiné à donner une somme pondérée des signaux de sortie du générateur de fonctions polynomes, cette somme étant appliquée à l'élément de commande l'oscillateur piézoélectrique à compensation de température étant caractérisé en ce que le générateur de fonctions polynomes est destiné à créer une série de signaux de sortie analogues à des signaux de Chebyshev dont le $n^{\text{ième}}$ signal de sortie est une fonction polynomiale en f(t) l'ordre (n−1), et en ce que l'amplificateur d'addition somme au moins quatre signaux différents de sortie du générateur de fonctions polynomes.

2. Oscillateur selon la revendication 1, caractérisé en ce que le signal de sortie d'ordre le plus élevé créé par le générateur de fonctions polynomes est le signal de sortie d'ordre trois.

3. Oscillateur selon l'une des revendications 1 et 2, caractérisé en ce que le cristal piézoélectrique est un cristal à taille AT.

4. Oscillateur selon l'une quelconque des revendications précédentes, caractérisé en ce que les composants actifs du capteur de température, du générateur de fonctions polynomes et de l'amplificateur d'addition sont disposés dans un ou plusieurs circuits intégrés.

5. Oscillateur selon la revendication 4, caractérisé en ce que le circuit intégré ou chaque circuit intégré a un arrangement analogique semi-personnalisé.

6. Oscillateur selon l'une des revendications 4 et 5, caractérisé en ce que le circuit ou les circuits intégrés comportent une référence de tension.

7. Oscillateur selon l'une quelconque des revendications 4, 5 et 6, caractérisé en ce que le circuit ou les circuits intégrés comprennent l'élément de réglage par déplacement de fréquence du circuit oscillateur.

8. Oscillateur selon l'une quelconque des revendications 4, 5, 6 et 7, caractérisé en ce que les seuls éléments séparés exclus d'un circuit paillette et appartenant au câblage du circuit intégré sont des résistances.

9. Oscillateur selon l'une quelconque des revendications 4, 5 et 6, caractérisé en ce que le circuit ou les circuits intégrés comportent le circuit oscillateur à l'exception de l'élément de commande à déplacement de fréquence et le cristal piézoélectrique lui-même.

10. Oscillateur selon la revendication 7, caractérisé en ce que le circuit ou les circuits intégrés comprennent le circuit oscillateur à l'exception du cristal piézoélectrique lui-même.

11. Oscillateur selon l'une des revendications 9 et 10, caractérisé en ce que les seuls composants du câblage du circuit intégré placés en dehors du circuit paillette sont des résistances et le cristal piézoélectrique.

12. Oscillateur selon l'une des revendications 8 et 10, caractérisé en ce que les résistances séparées du circuit paillette sont des résistances de la série E24 ayant une précision de 2%.

13. Oscillateur selon l'une quelconque des revendications 4 à 12, caractérisé en ce que le capteur de température comporte un circuit destiné à donner des signaux de sortie soux forme de courants sensiblement linéaires à coefficient positif et négatif de variation en fonction de la température ayant des modules pratiquement égaux, tirés tous deux de la caractéristique des tensions base-émetteur d'éléments du circuit paillette de circuit intégré en fonction de la température.

14. Oscillateur selon l'une quelconque des revendications précédentes, caractérisé en ce que l'élément de commande à déplacement de fréquence est une diode à variation de capacité.